# EUROPEAN PATENT APPLICATION

(11) **EP 4 475 198 A1**
(43) Date of publication of application: **11.12.2024**
(21) Application number: 23749749.0
(22) Date of filing: 31.01.2023
(51) Int. Cl.: H01L 33/32, H01L 33/06, H01L 33/44

(54) **METHOD FOR PRODUCING LIGHT EMITTING ELEMENT, AND LIGHT EMITTING ELEMENT**

(30) Priority: 01.02.2022 JP 2022014115
(71) Applicant: University Public Corporation Osaka, Osaka-shi, Osaka 545-0051 (JP); Kyoto University, Kyoto-shi, Kyoto 606-8501 (JP)
(72) Inventor: OKAMOTO Koichi, Sakai-shi, Osaka 599-8531 (JP); KAITO Seiya, Sakai-shi, Osaka 599-8531 (JP); MATSUYAMA Tetsuya, Sakai-shi, Osaka 599-8531 (JP); WADA Kenji, Sakai-shi, Osaka 599-8531 (JP); KAWAKAMI Yoichi, Kyoto-shi, Kyoto 606-8501 (JP); FUNATO Mitsuru, Kyoto-shi, Kyoto 606-8501 (JP)
(74) Representative: advotec.
(86) International application number: PCT/JP2023/003083
(87) International publication number: WO 2023/149433

(57) **Abstract**

A method for producing a light emitting device made of GaN-based semiconductor includes a step of forming a light emitting layer 12 having a quantum well structure on a substrate 10, a step of forming a cap layer 13 made of GaN on the light emitting layer, and a step of forming an oxide film 14 on the cap layer. The oxide film is made of oxide having an element which can be diffused and enter a Ga vacancy in the cap layer made of GaN.

## Description

### TECHNICAL FIELD

The present invention relates to a method for producing a light emitting device made of GaN-based semiconductor and a light emitting device.

### BACKGROUND ART

As a light emitting device, such as a light emitting diode, made of GaN-based semiconductor, there has been known a light emitting device including a light emitting layer having a quantum well structure and made of InGaN.

InGaN is a mixed crystal of GaN and InN, and the band gap energy thereof can be changed by adjustment of the composition ratio thereof. In this manner, an emission wavelength can be controlled. However, under the current circumstances, a high light emitting efficiency is obtained in a blue spectral range, but the light emitting efficiency is extremely low in other ranges.

As an approach for improving the light emitting efficiency, there has been proposed a method using surface plasmon resonance (Non-Patent Document 1). In this method, a method a metal thin film is formed in the vicinity of an InGaN light emitting layer with a GaN layer (cap layer) interposed therebetween, and upon light emission by recombination, an electron-hole pair in the InGaN light emitting layer resonates with surface plasmon at an interface between the metal thin film and the GaN layer, and a light emitting rate increases. As a result, the light emitting efficiency is improved.

### CITATION LIST

### NON-PATENT DOCUMENT

NON-PATENT DOCUMENT 1: Applied Physics Letters, vol. 87, 7110, page 2, 2005

### SUMMARY OF THE INVENTION

### TECHNICAL PROBLEM

In the method using the surface plasmon resonance, light from the light emitting layer is absorbed by the metal thin film, and therefore, there is a problem that an optical loss is great and there is no metal material suitable for a green spectral range.

The present invention has been made in view of the above-described point, and an object thereof is to provide a method for producing a light emitting device made of GaN-based semiconductor and having an improved light emitting efficiency and provide a light emitting device.

### SOLUTION TO THE PROBLEM

The method for producing the light emitting device according to the present invention is a method for producing a light emitting device made of GaN-based semiconductor, the method including a step of forming a light emitting layer having a quantum well structure on a substrate, a step of forming a cap layer made of GaN on the light emitting layer, and a step of forming an oxide film on the cap layer. The oxide film is made of oxide having an element which can be diffused and enter a Ga vacancy in the cap layer made of GaN.

The light emitting device according to the present invention is a light emitting device made of GaN-based semiconductor, the light emitting device including a light emitting layer having a quantum well structure, a cap layer formed on the light emitting layer and made of GaN, and a ZnO film formed on the cap layer.

### ADVANTAGES OF THE INVENTION

According to the present invention, the method for producing the light emitting device made of the GaN-based semiconductor and having the improved light emitting efficiency and the light emitting device can be provided.

### BRIEF DESCRIPTION OF THE DRAWINGS

[FIG. 1] FIG. 1 shows a schematic sectional view of the structure of a sample produced for describing the present invention.
[FIG. 2] FIG. 2 shows graphs of measurement results of photoluminescence (PL) obtained in such a manner that a sample configured such that a SiO₂ film is formed on a GaN layer (cap layer) is irradiated with excitation light.
[FIG. 3] FIG. 3 shows graphs of measurement results of the temperature dependence of an emission intensity for a yellow-green light emitting sample.
[FIG. 4] FIG. 4 shows graphs of measurement results of a change in the emission intensity for different laser irradiation times for the yellow-green light emitting sample.
[FIG. 5] FIG. 5 shows graphs obtained in such a manner that the emission intensity is plotted for the laser irradiation time.
[FIG. 6] FIG. 6 shows graphs of measurement results of the photoluminescence (PL) for a sample from which the SiO₂ film is removed after laser irradiation of a surface of the SiO₂ film.
[FIG. 7] FIG. 7 shows graphs of measurement results of the photoluminescence (PL) for a sample configured such that a ZnO film is formed on the GaN layer (cap layer).
[FIG. 8] FIG. 8 shows graphs of measurement results of a change in the emission intensity for different laser irradiation times.
[FIG. 9] FIG. 9 shows graphs obtained in such a manner that the emission intensity is plotted for the laser irradiation time.
[FIG. 10] FIG. 10 shows graphs of measurement results of a time-resolved emission profile for the sample configured such that the SiO₂ film is formed on the GaN layer (cap layer).
[FIG. 11] FIG. 11 shows graphs of measurement results of a Si concentration in the GaN layer (cap layer).
[FIG. 12] FIGS. 12(A) to 12(C) show graphs obtained in such a manner that emission intensities for different thicknesses of the GaN layer (cap layer) are plotted for the laser irradiation time.
[FIG. 13] FIG. 13 shows graphs of measurement results of an emission intensity ratio between the sample configured such that the SiO₂ film is formed on the GaN layer (cap layer) and a sample formed with no SiO₂ film for different thicknesses of the GaN layer (cap layer).
[FIG. 14] FIG. 14 shows a schematic sectional view of the configuration of a light emitting device of the present invention.
[FIG. 15] FIG. 15 shows a schematic sectional view of another configuration of the light emitting device of the present invention.
[FIG. 16] FIG. 16 shows a sectional view of a variation of the light emitting device of the present invention.

### DESCRIPTION OF EMBODIMENTS

The inventors et al. of the present application have found such a remarkable phenomenon that a light emitting efficiency is significantly improved by formation of an oxide film made of a particular material on a surface of a GaN layer formed on a surface of an InGaN light emitting layer instead of formation of a metal thin film.

### (Enhancement of light emission using SiO₂ film)

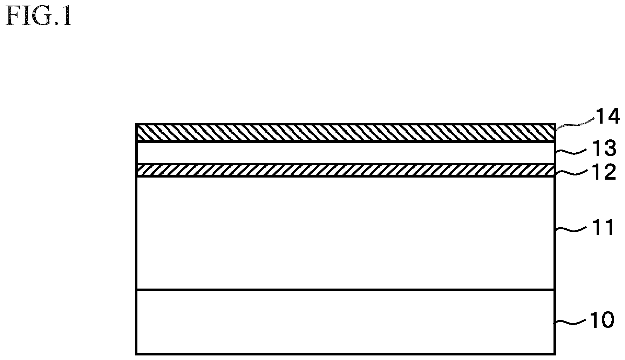

FIG. 1 shows a schematic sectional view of the structure of a sample produced for verifying the above-described phenomenon.

As shown in FIG. 1, a GaN layer 11 with a thickness of 3 µm was formed on a sapphire substrate 10, and an InGaN layer (light emitting layer) 12 having a quantum well structure with a thickness of 3 nm was formed on the GaN layer 11. Further, a GaN layer (cap layer) 13 with a thickness of 10 nm was formed on the InGaN layer 12, and a SiO₂ film 14 with a thickness of 5 nm was formed on the GaN layer 13. Further, a surface of the SiO₂ film 14 was irradiated with a He-Cd laser (wavelength: 325 nm; intensity: 200 mW) for ten minutes. Note that in order to check light emission from the sample according to a later-described photoluminescence (PL), the GaN layer 11 and the GaN layer (cap layer) 13 were non-doped layers in the produced sample. Note that in a case where a light emitting device such as an LED is formed, the GaN layer 11 may be of an n-type, and the GaN layer (cap layer) 13 may be of a p-type.

Here, the In composition ratio of the InGaN layer (light emitting layer) 12 was adjusted such that blue light (470 nm), green light (510 nm), and yellow-green light (540 nm) are emitted. Moreover, each of the GaN layer 11, the InGaN layer 12, and the GaN layer 13 was formed by metal organic chemical vapor deposition, and the SiO₂ film 14 was formed by sputtering.

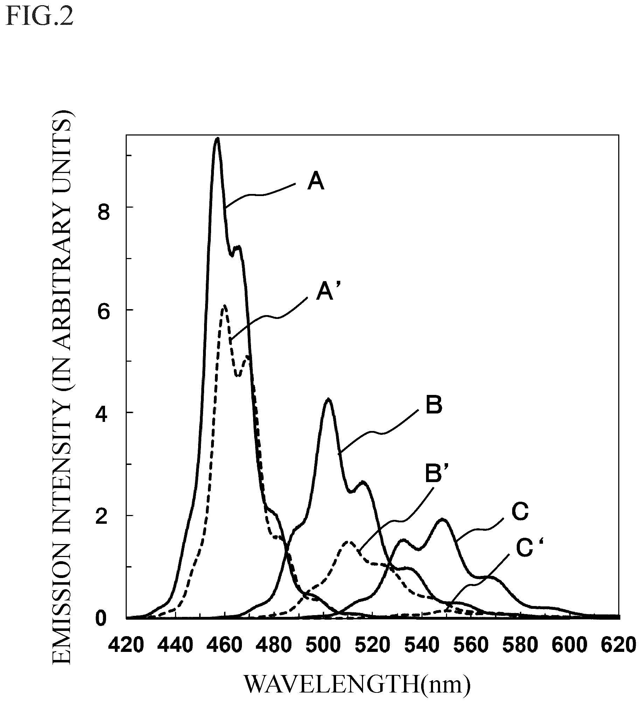

FIG. 2 shows graphs of measurement results of the photoluminescence (PL) obtained in such a manner that the sample configured such that the SiO₂ film 14 is formed on the GaN layer (cap layer) 13 and a sample configured such that no SiO₂ film 14 is formed are irradiated with light from the He-Cd laser (wavelength: 325 nm; intensity: 200 mW). Here, graphs indicated by solid lines A, B, C each show samples formed with SiO₂ films 14 and being capable of emitting blue light, green light, and yellow-green light. Moreover, graphs indicated by dashed lines A', B', C' each show samples formed with no SiO₂ films 14 and being capable of emitting blue light, green light, and yellow-green light.

FIG. 2 shows that as compared to the emission intensity of the sample formed with no SiO₂ film 14, the emission intensity of the sample formed with the SiO₂ film 14 is enhanced by about 1.5 times in the case of blue light emission, about 2.5 times in the case of green light emission, and about 13 times in the case of yellow-green light emission.

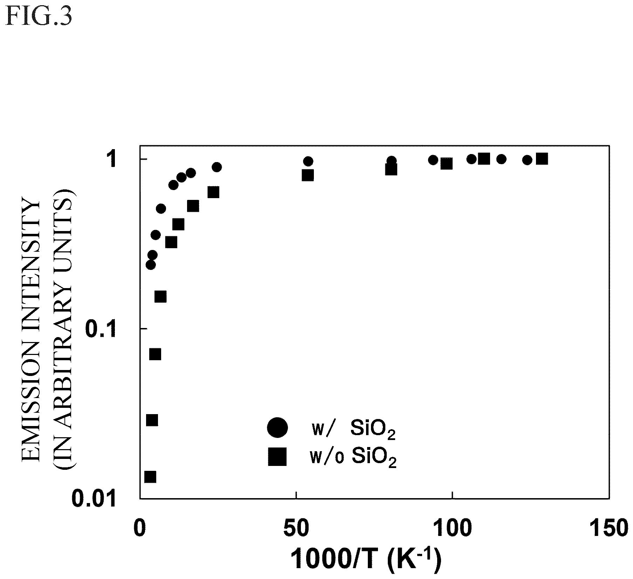

FIG. 3 shows graphs of measurement results of the temperature dependence of the emission intensity for the yellow-green light emitting sample whose emission intensity was most enhanced. Here, a graph indicated by black circles shows the sample formed with the SiO₂ film 14, and a graph indicated by black rectangles shows the sample formed with no SiO₂ film 14.

As shown in FIG. 3, the emission intensity increases as the temperature decreases, and shows a constant value at an extremely-low temperature. This is because motion of exciton by heat decreases as the temperature decreases, exciton is less likely to be captured by a nonradiative site due to, e.g., an impurity or dislocation/defect, and thermal inactivation leading to a decrease in the light emitting efficiency is reduced. Thus, it is assumed that the internal quantum efficiency of the emission when the emission intensity is constant at the extremely-low temperature is almost 100%, and by comparison with this value, the value of the internal quantum efficiency of the emission at each temperature can be estimated. Thus, the sample formed with no SiO₂ film 14 showed an internal quantum efficiency of 1.3% while the sample formed with the SiO₂ film 14 showed an internal quantum efficiency increased to 22%.

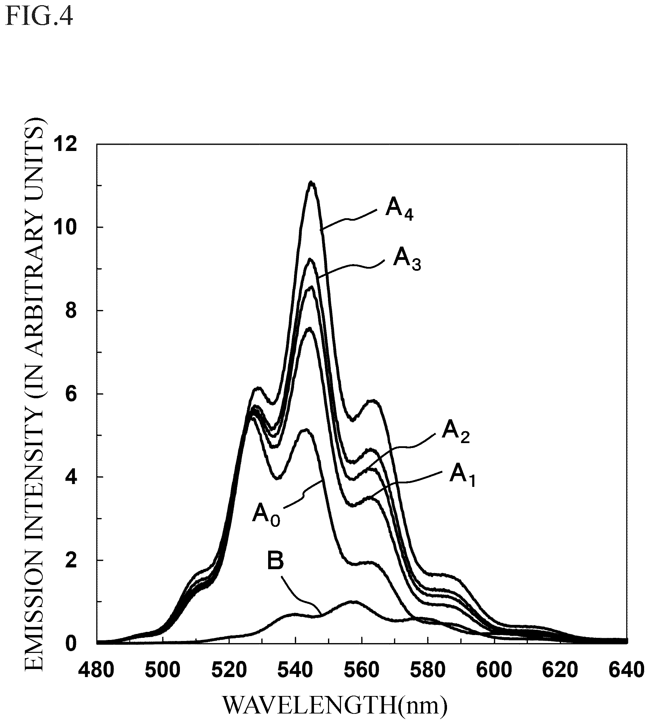

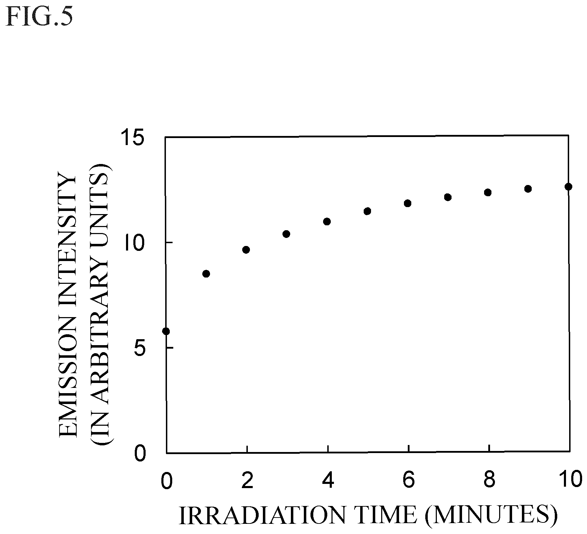

FIG. 4 shows, for the yellow-green light emitting sample, graphs of measurement results of a change in the emission intensity for different laser irradiation times. Here, graphs indicated by A₀, A₁, A₂, A₃, A₄ each show emission intensities when the laser irradiation time is zero minutes (no irradiation), one minute, three minutes, five minutes, and eight minutes. Note that a graph indicated by B shows the sample formed with no SiO₂ film 14. Moreover, FIG. 5 shows graphs obtained in such a manner the emission intensity is plotted for the laser irradiation time.

FIG. 4 shows that the emission intensity increases as the laser irradiation time increases. Moreover, FIG. 5 shows that the emission intensity is saturated after laser irradiation for a certain time. Note that even in the case of no laser irradiation (graph indicated by A₀), the emission intensity is improved by about five times as compared to the sample formed with no SiO₂ film 14.

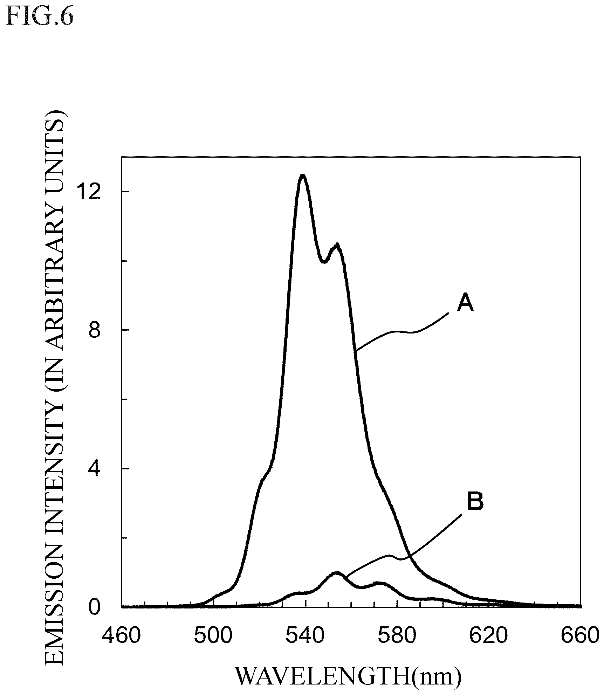

FIG. 6 shows graphs of measurement results of the photoluminescence (PL) for a sample produced in such a manner that after the surface of the SiO₂ film 14 has been irradiated with the laser, the SiO₂ film 14 is removed from the GaN layer (cap layer) 13 using hydrofluoric acid. Here, a graph indicated by A shows the sample from which the SiO₂ film 14 has been removed, and a graph indicated by B shows the sample formed with no SiO₂ film 14 in the first place.

FIG. 6 shows that even the sample from which the SiO₂ film 14 has been removed maintains a high emission intensity which is substantially equal to that of the sample having the SiO₂ film 14 with the laser-irradiated surface.

### (Enhancement of light emission using a ZnO film)

A sample was produced, which is configured such that a ZnO film with a thickness of 5 nm is formed as the oxide film 14 formed on the GaN layer (cap layer) 13 instead of the SiO₂ film. The ZnO film was formed by sputtering, and a configuration other than the ZnO film was the same as that of the sample shown in FIG. 1. The In composition ratio of InGaN layer (light emitting layer) 12 was adjusted such that yellow-green light (540 nm) is emitted. Moreover, a surface of the ZnO film was irradiated with a He-Cd layer (wavelength: 325 nm; intensity: 200 mW) for ten minutes.

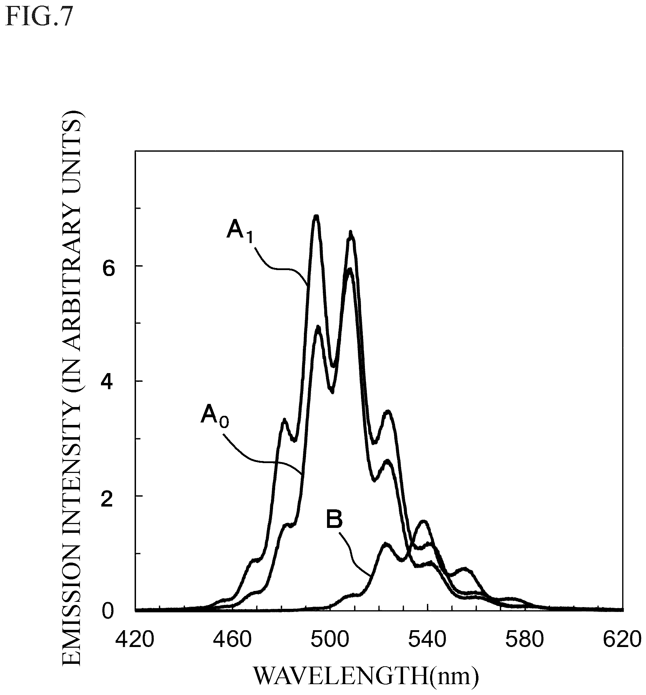

FIG. 7 shows graphs of measurement results of the photoluminescence (PL) obtained in such a manner that the sample configured such that the ZnO film is formed on the GaN layer (cap layer) 13 and a sample configured such that no ZnO film is formed are irradiated with light excited by the He-Cd laser (wavelength: 325 nm; intensity: 200 mW). Here, a graph indicated by A₀ shows a sample for which no laser irradiation was performed after formation of the ZnO film, a graph indicated by A₁ shows a sample for which laser irradiation was performed after formation of the ZnO film, and a graph indicated by B shows the sample formed with no ZnO film.

FIG. 7 shows that as compared to the emission intensity of the sample formed with no ZnO film, the emission intensity of the sample for which laser irradiation was performed after formation of the ZnO film is enhanced by about seven times.

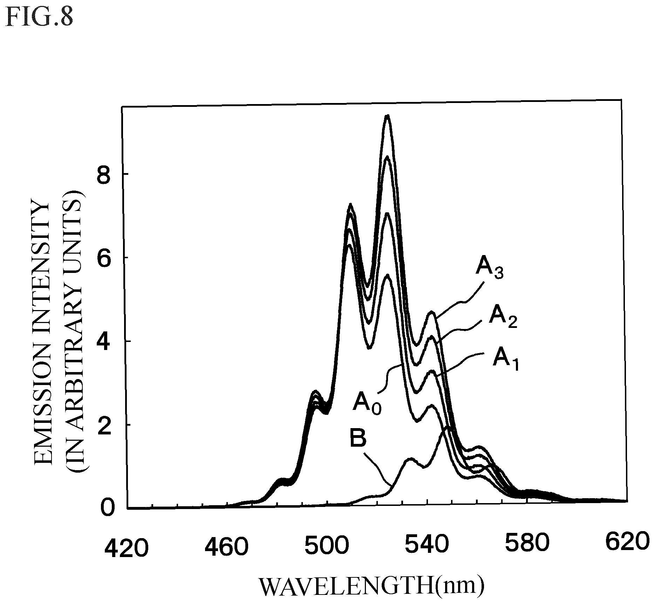

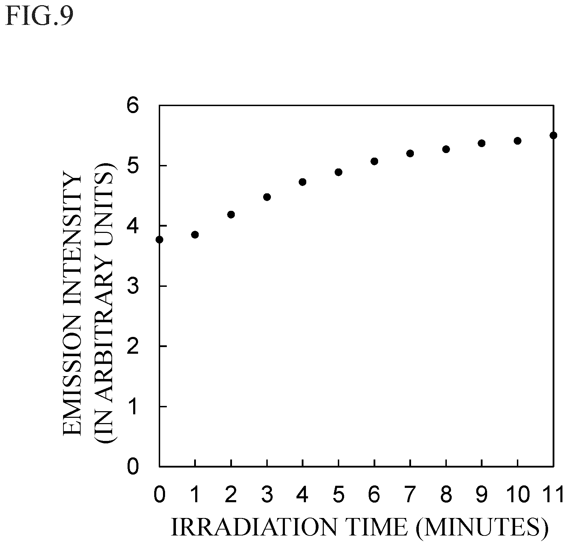

FIG. 8 shows graphs of measurement results of a change in the emission intensity for different laser irradiation times. Here, graphs indicated by A₀, A₁, A₂, A₃ each show emission intensities when the laser irradiation time is zero minutes (no irradiation), one minute, three minutes, five minutes, and eight minutes. Note that a graph indicated by B shows the sample formed with no ZnO film. Moreover, FIG. 9 shows graphs obtained in such a manner the emission intensity is plotted for the laser irradiation time.

FIG. 8 shows that the emission intensity increases as the laser irradiation time increases. Moreover, FIG. 9 shows that the emission intensity is saturated after laser irradiation for a certain time. Note that even in the case of no laser irradiation (graph indicated by A₀), the emission intensity is improved by about three times as compared to the sample formed with no ZnO film.

Even the sample from which the ZnO film was removed after laser irradiation maintained a high emission intensity which is substantially equal to that of the sample having the ZnO film with the laser-irradiated surface.

The above-described results show that the emission intensity is improved by formation of the particular oxide film (SiO₂ film or ZnO film) 14 on the GaN layer (cap layer) 13 and is significantly improved by laser irradiation of the surface of the oxide film (SiO₂ film or ZnO film) 14. Moreover, the results show that a high emission intensity is maintained even in a case where the oxide film (SiO₂ film or ZnO film) 14 is removed after laser irradiation.

### (Mechanism for improving emission intensity)

A reason why the light emitting efficiency is improved to a certain extent by formation of the SiO₂ film or the ZnO film on the GaN layer (cap layer) 13 and is significantly improved by laser irradiation of the surface of the SiO₂ film or the ZnO film is not known exactly, but it is assumed that such a phenomenon occurs due to the following mechanism.

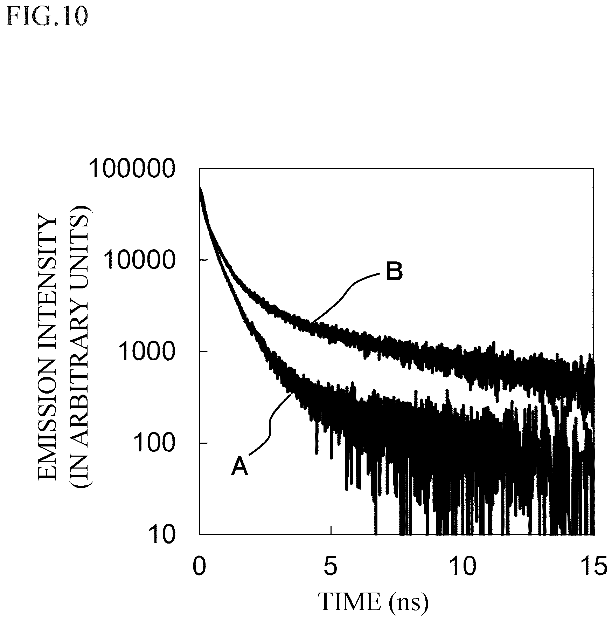

FIG. 10 shows graphs of measurement results of a time-resolved emission profile for the sample configured such that the SiO₂ film 14 is formed on the GaN layer (cap layer) 13 and the same configured such that no SiO₂ film 14 is formed. Here, a graph indicated by A shows the sample formed with the SiO₂ film 14, and a graph indicated by B shows the sample formed with no SiO₂ film 14.

FIG. 10 shows that the sample formed with the SiO₂ film 14 has a shorter emission lifetime, and this means that an electron-hole pair recombination rate in the InGaN layer (light emitting layer) 12 increases. A cause for such an increase in the recombination rate is assumed to be improvement in the crystalline quality of the GaN layer (cap layer) 13 on the InGaN layer (light emitting layer) 12.

As described above, the light emitting efficiency can be improved to a certain extent by formation of the SiO₂ film or the ZnO film as the oxide film 14 on the GaN layer (cap layer) 13, and is significantly improved by irradiation of the surface of the SiO₂ film or the ZnO film with the laser with a wavelength of 325 nm. On the other hand, in a case where an Al₂O₃ film is formed as another oxide film on the GaN layer (cap layer) 13, the light emitting efficiency is not improved.

Normally, there are Ga vacancies in the GaN layer 13, and these Ga vacancies influence the light emitting efficiency of the InGaN layer (light emitting layer) 12. As shown in Table 1, the covalent radii of Si, Zn, and Al are similar to or less than the covalent radius of Ga, and therefore, Si, Zn, and Al in the SiO₂ film, the ZnO film, and Al₂O₃ film can be diffused into the Ga vacancies in the GaN layer 13.

**[Table 1]**

| Element | Covalent Radius (A) |
|---|---|
| Ga | 1.22 |
| Si | 1.11 |
| Zn | 1.22 |
| Al | 1.18 |

An effect of significantly improving the light emitting efficiency is obtained by irradiation with the laser with a wavelength of 325 nm, and this wavelength is equivalent to an energy of 3.8 eV. As shown in Table 2, this energy is higher than a bond energy (3.1 eV) between Si and O (oxygen) and a bond energy (2.2 eV) between Zn and O (oxygen), and is lower than a bond energy (5.3 eV) between Al and O (oxygen).

**[Table 2]**

| Bond Type | Bond Energy [eV] |
|---|---|
| Si-O | 3.1 |
| Zn-O | 2.2 |
| Al-O | 5.3 |

In view of the above-described points, it is assumed that the bond between Si or Zn and O is disconnected by irradiation of the surface of the SiO₂ film or the ZnO film with the laser with a wavelength of 325 nm, Si or Zn is diffused and enters the Ga vacancies in the crystals of the GaN layer (cap layer) 13, and the crystalline quality of the GaN layer (cap layer) 13 is improved accordingly. As a result, the internal quantum efficiency of the InGaN layer (light emitting layer) 12 is improved, and the light emitting efficiency is improved.

In addition, a wavelength equivalent to the band gap of GaN is 365 nm, and therefore, when the surface of the SiO₂ film or the ZnO film is irradiated with the laser with a wavelength of 325 nm which is shorter than such a wavelength, light having penetrated the SiO₂ film or the ZnO film is absorbed by the GaN layer (cap layer) 13, the GaN layer (cap layer) 13 generates heat, and the temperature thereof increases. Accordingly, diffusion of Si or Zn from the SiO₂ film or the ZnO film into the crystals of the GaN layer (cap layer) 13 is promoted, and therefore, entrance into the Ga vacancies in the crystals of the GaN layer (cap layer) 13 is further promoted. As a result, the crystalline quality of the GaN layer (cap layer) 13 is further improved, the internal quantum efficiency of the InGaN layer (light emitting layer) 12 is improved, and the light emitting efficiency is improved.

In order to verify the above-described mechanism, measurement of elements in the GaN layer (cap layer) by secondary ion mass spectrometry (SIMS) was performed for the sample having the SiO₂ film with the surface irradiated with the laser after formation of the SiO₂ film (thickness: 5 nm) on the GaN layer (thickness: 10 nm) 13. Note that measurement was performed after removal of the SiO₂ film from the GaN layer 13.

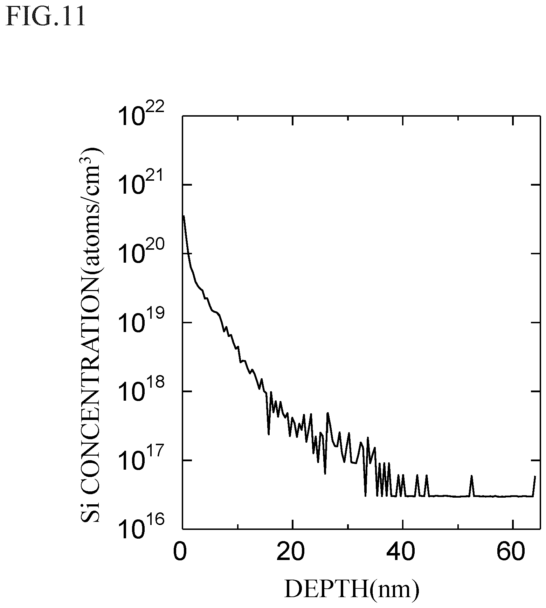

FIG. 11 shows results of such measurement, and it was confirmed that Si is distributed with a concentration of 10¹⁸ to 10¹⁹ atoms/cm³ in a region from the surface of the GaN layer to 20 nm, at which a quantum well related to light emission is present, in a depth direction.

On the other hand, even when the surface of the Al₂O₃ film is irradiated with the laser with a wavelength of 325 nm, the bond between Al and O is not disconnected. Thus, the crystalline quality of the GaN layer (cap layer) 13 is not improved, and the effect of improving the light emitting efficiency is not obtained.

Note that in order to obtain the effect of improving the light emitting efficiency by laser irradiation, the surface of the SiO₂ film or the ZnO film on the GaN layer (cap layer) 13 is preferably irradiated with laser which has a wavelength with an energy greater than the bond energy between Si or Zn and O (oxygen). Moreover, the surface of the SiO₂ film or the ZnO film on the GaN layer (cap layer) 13 is preferably irradiated with laser which has a wavelength with an energy greater than the band gap energy of GaN.

Note that not only the Ga vacancies but also N vacancies are present in the vicinity of the surface of the GaN layer (cap layer) 13, and therefore, it is assumed that O disconnected from Si or Zn is diffused into the N vacancies and the crystalline quality of the GaN layer (cap layer) 13 is improved accordingly.

The light emitting efficiency is improved to a certain extent only by formation of the SiO₂ film or the ZnO film on the GaN layer (cap layer) by sputtering because it is assumed that in sputtering for forming the SiO₂ film or the ZnO film, a certain number of Si or Zn is diffused and enters the Ga vacancies in the vicinity of the surface of the GaN layer (cap layer) 13 and the crystalline quality of the GaN layer (cap layer) 13 is improved accordingly.

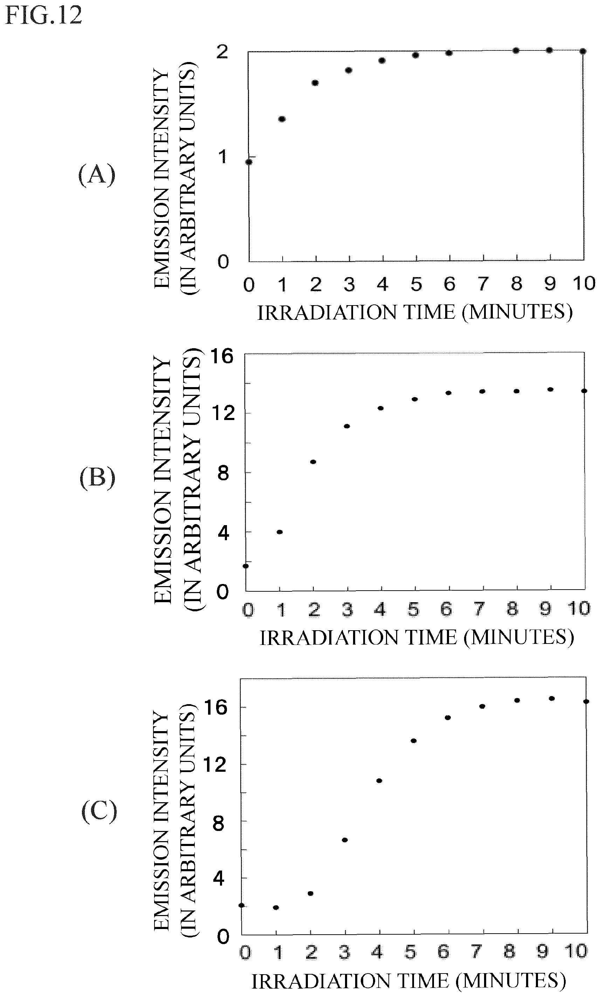

FIGS. 12(A) to 12(C) show, for the sample configured such that the SiO₂ film with a thickness of 5 nm is formed on the GaN layer (cap layer) 13, graphs obtained in such a manner that emission intensities for different thicknesses of the GaN layer (cap layer) 13 are plotted for the laser irradiation time. FIGS. 12(A), 12(B), and 12(C) show samples configured such that the thicknesses of the GaN layer (cap layer) 13 are 5 nm, 25 nm, and 40 nm.

FIGS. 12(A) to 12(C) show that the time until the emission intensity is saturated increases as the thickness of the GaN layer (cap layer) increases. This may be because a time until Si diffused into the GaN layer (cap layer) 13 by laser irradiation reaches the InGaN layer (light emitting layer) 12 increases and a time until the crystalline quality of the GaN layer (cap layer) 13 is improved increases accordingly.

### (Thickness of cap layer)

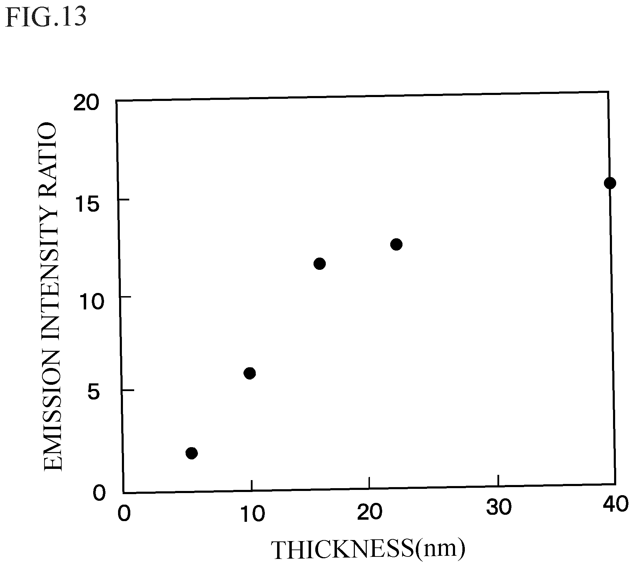

FIG. 13 shows graphs of measurement results of a ratio (emission intensity ratio) between the emission intensity of the sample shown in FIG. 1 and configured such that the SiO₂ film 14 is formed on the GaN layer (cap layer) 13 and the emission intensity of the sample formed with no SiO₂ film for different thicknesses of the GaN layer (cap layer) 13.

FIG. 13 shows that the emission intensity ratio is improved as the thickness of the GaN layer (cap layer) 13 increases. Note that the thickness of the GaN layer (cap layer) 13 is preferably 5 nm or more. If the thickness of the GaN layer (cap layer) 13 is less than 5 nm, it is not preferred because the InGaN layer (light emitting layer) 12 receives damage due to sputtering for forming the SiO₂ film 14 and the effect of improving the light emitting efficiency cannot be obtained.

Moreover, the thickness of the GaN layer (cap layer) 13 is preferably 150 nm or less. If the thickness of the GaN layer (cap layer) 13 exceeds 150 nm, it is not preferred because a distance between the InGaN layer (light emitting layer) 12 and the SiO₂ film 14 extremely increases, Si is not diffused to the vicinity of the InGaN layer (light emitting layer) 12, and the effect of improving the light emitting efficiency cannot be obtained. Further, the thickness of the GaN layer (cap layer) 13 is more preferably 100 nm or less. A distance by which the laser with a wavelength of 325 nm can enter the GaN layer (cap layer) 13 is about 100 nm, and therefore, if the thickness of the GaN layer (cap layer) 13 exceeds 100 nm, it is not preferred because a sufficient temperature increase by heat generation of the GaN layer (cap layer) 13 cannot be achieved and the effect of improving the light emitting efficiency cannot be obtained.

### (Thickness of oxide film)

In the present invention, the thickness of the oxide film (SiO₂ film or ZnO film) 14 on the GaN layer (cap layer) 13 is preferably 1 nm or more because it is difficult to form a thin film if the thickness of less than 1 nm.

### (Method for producing light emitting device)

A method for producing the light emitting device in the present invention includes a step of forming the light emitting layer 12 having the quantum well structure on the substrate 10, a step of forming the cap layer 13 made of GaN on the light emitting layer 12, and a step of forming the oxide film 14 on the cap layer 13. The oxide film 14 is made of an oxide having an element which can be diffused and enter the Ga vacancies in the cap layer 13 made of GaN.

The oxide film 14 is preferably the SiO₂ film or the ZnO film, and is preferably formed by sputtering.

The method preferably further includes a step of irradiating the surface of the oxide film 14 on the cap layer 13 with light which has a wavelength with a greater energy than a bond energy between the element (Si in the case of the SiO₂ film, Zn in the case of the ZnO film) forming the oxide film 14 and oxygen.

The method may further include a step of removing the oxide film 14 from the cap layer 13.

In the cap layer 13, at least one or both of the element forming the oxide film 14 and oxygen are present.

According to the method for producing the light emitting device in the present invention, the light emitting device made of the GaN semiconductor can have the improved light emitting efficiency. Particularly, the light emitting device can be provided, which has a high light emitting efficiency in the wavelength range of green light (510 nm) or yellow-green light (540 nm).

### (Structure of light emitting device)

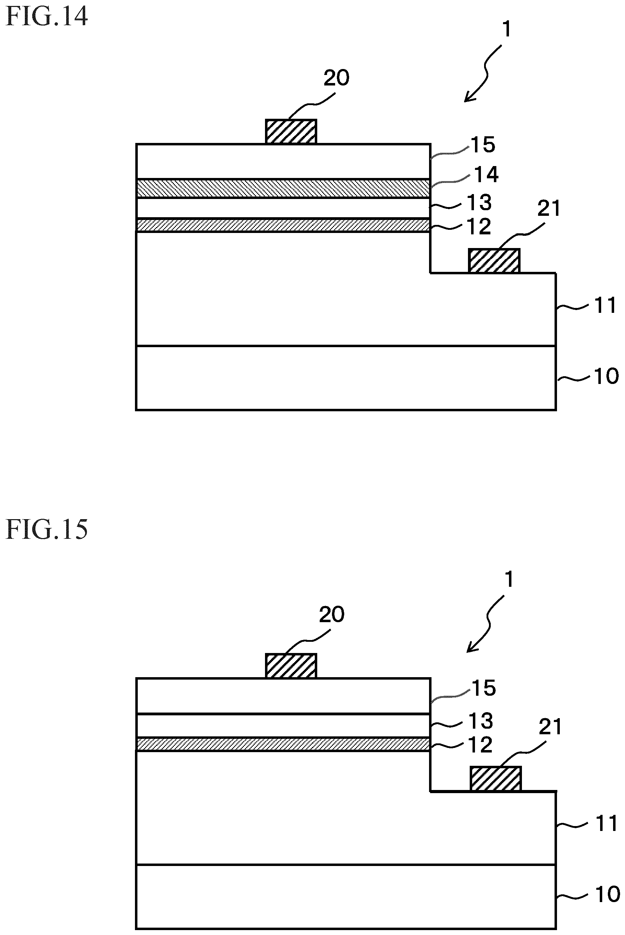

FIG. 14 shows a schematic sectional view of the configuration of the light emitting device (light emitting diode) produced by the method for producing the light emitting device in the present invention.

As shown in FIG. 14, the light emitting device 1 includes the n-type GaN layer 11 formed on the substrate 10, the light emitting layer 12 formed on the n-type GaN layer 11 and having the quantum well structure, the cap layer 13 formed on the light emitting layer 12 and made of p-type GaN, and the ZnO film 14 formed on the cap layer 13.

Here, the ZnO film 14 is preferably a film formed by sputtering. Moreover, the surface of the ZnO film 14 is preferably irradiated with light which has a wavelength with a greater energy than a bond energy between zinc (Zn) and oxygen (O).

The ZnO film 14 has conductivity, and therefore, a transparent electrode film 15 is formed on the ZnO film 14 and electrodes 20, 21 are each formed on the transparent electrode film 15 and the n-type GaN layer 11 so that current can be injected into the light emitting layer 12 and light can be taken out from the light emitting layer 12.

In a case where the SiO₂ film is formed on the cap layer 13, the SiO₂ film is an insulating film. Thus, as shown in FIG. 15, the SiO₂ film is removed from the cap layer 13, and thereafter, the transparent electrode film 15 is formed on the cap layer 13 and the electrodes 20, 21 are each formed on the transparent electrode film 15 and the n-type GaN layer 11. In this manner, current can be injected into the light emitting layer 12, and light can be taken out from the light emitting layer 12. Note that the effect of improving the light emitting efficiency is maintained even after the SiO₂ film has been removed from the cap layer 13, and therefore, the light emitting device having a high light emitting efficiency can be obtained.

### (Variation of light emitting device)

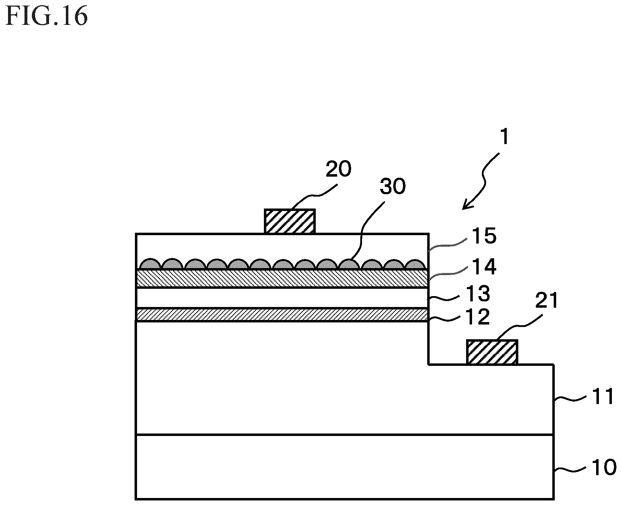

FIG. 16 shows a sectional view of a variation of the light emitting device in the present invention.

The light emitting device 1 shown in FIG. 16 is different from the light emitting device 1 shown in FIG. 14 in that a plasmon layer 30 that plasmon-resonates with light emitted from the light emitting layer 12 is further formed on the ZnO film 14. Here, the plasmon layer 30 is formed of a metal thin film or metal fine particles made of a material such as Ag, Al, Au, or Cu.

It has been known that the plasmon layer 30 is formed on the surface of the p-type GaN layer 13 on the InGaN light emitting layer 12 so that the light emitting efficiency can be improved by a plasmon effect (Non-Patent Document 1), but there is a problem that metal atoms are diffused from the metal thin film or the metal fine particles forming the plasmon layer 30 into the p-type GaN layer 13, the structure of the plasmon layer 30 is broken over time, and the plasmon effect is degraded.

As shown in FIG. 16, the light emitting device 1 in the present variation is configured such that the plasmon layer 30 is formed on the p-type GaN layer (cap layer) 13 through the ZnO film 14, and therefore, diffusion of the metal atoms from, e.g., the metal thin film forming the plasmon layer 30 into the p-type GaN layer 13 can be prevented. Accordingly, the structure of the plasmon layer 30 can be stabilized, and the plasmon effect can be maintained.

In the light emitting device 1 of the present variation, not only the light emitting efficiency can be improved by formation of the ZnO film 14 on the p-type GaN layer 13, but also the light emitting efficiency can be further improved by formation of the plasmon layer 30 on the ZnO film 14. Thus, the light emitting device 1 having a higher light emitting efficiency can be provided.

Note that in the present variation, if the thickness of the ZnO film 14 is too great, the electric field of the plasmon layer 30 does not reach the InGaN light emitting layer 12 and the plasmon effect is not provided. For this reason, the thickness of the ZnO film 14 is preferably 10 nm or less.

The present invention has been described above with reference to the preferred embodiments, but is not limited to such description. Needless to say, various modifications can be made. For example, in the above-described embodiments, the oxide film 14 such as the SiO₂ film or the ZnO film is formed on the p-type GaN layer (cap layer) 13, but a nitride film such as a Si₃N₄ film may be formed. In this case, for example, a surface of the Si₃N₄ film is irradiated with laser which has a wavelength with a greater energy than a bond energy between Si and N (nitrogen), and in this manner, the bond between Si and N is disconnected and Si is diffused and enters the Ga vacancies in the p-type GaN layer (cap layer) 13. Accordingly, the crystalline quality of the p-type GaN layer (cap layer) 13 is improved.

In the above-described embodiments, the InGaN layer having the single quantum well structure has been described as an example of the light emitting layer 12, but the present invention is not limited thereto and an InGaN layer having a multiple quantum well structure may be used. Moreover, the light emitting layer 12 is not limited to the InGaN layer, and, e.g., an AlGaN layer may be used.

In the above-described embodiments, the light emitting diode has been described as an example of the light emitting device 1, but the present invention is not limited thereto and is also applicable to, e.g., a semiconductor laser.

### DESCRIPTION OF REFERENCE CHARACTERS

- 1: Light Emitting Device
- 10: Substrate
- 11: (n-type) GaN Layer
- 12: InGaN Layer (Light Emitting Layer)
- 13: (p-type) GaN Layer (Cap Layer)
- 14: Oxide Film (SiO₂ Film, ZnO Film)
- 15: Transparent Electrode Film
- 20, 21: Electrode
- 30: Plasmon Layer

## Claims

1. A method for producing a light emitting device made of GaN-based semiconductor, comprising:
a step of forming a light emitting layer having a quantum well structure on a substrate;
a step of forming a cap layer made of GaN on the light emitting layer; and
a step of forming an oxide film on the cap layer,
wherein the oxide film is made of oxide having an element which is able to be diffused and enter a Ga vacancy in the cap layer made of GaN.

2. The method for producing the light emitting device according to claim 1, wherein
the oxide film is formed by sputtering.

3. The method for producing the light emitting device according to claim 1, further comprising:
a step of irradiating a surface of the oxide film on the cap layer with light which has a wavelength with a greater energy than a bond energy between the element and oxygen forming the oxide film.

4. The method for producing the light emitting device according to claim 1, further comprising:
a step of irradiating a surface of the oxide film on the cap layer with laser which has a wavelength with a greater energy than a band gap energy of GaN.

5. The method for producing the light emitting device according to claim 1, further comprising:
a step of removing the oxide film from the cap layer.

6. The method for producing the light emitting device according to claim 1, further comprising:
a step of forming, on a surface of the oxide film, a plasmon layer that plasmon-resonates with light emitted from the light emitting layer.

7. The method for producing the light emitting device according to claim 1, wherein
after the step of forming the oxide film on the cap layer, at least one or both of the element and oxygen forming the oxide film are present in the cap layer.

8. The method for producing the light emitting device according to claim 1, wherein
the oxide film is a SiO₂ film or a ZnO film.

9. The method for producing the light emitting device according to claim 1, wherein
a thickness of the oxide film is 1 nm or more.

10. The method for producing the light emitting device according to claim 1, wherein
a thickness of the cap layer is within a range of 5 nm to 150 nm.

11. The method for producing the light emitting device according to claim 6, wherein
the plasmon layer is formed of a metal thin film or metal fine particles.

12. A light emitting device made of GaN-based semiconductor, comprising:
a light emitting layer having a quantum well structure;
a cap layer formed on the light emitting layer and made of GaN; and
a ZnO film formed on the cap layer.

13. The light emitting device according to claim 12, wherein
the ZnO film is a film formed by sputtering.

14. The light emitting device according to claim 12, wherein
a thickness of the cap layer is within a range of 5 nm to 150 nm.

15. The light emitting device according to claim 12, wherein
a surface of the ZnO film is irradiated with light which has a wavelength with a greater energy than a bond energy between zinc (Zn) and oxygen (O).

16. The light emitting device according to claim 12, wherein
at least one or both of zinc (Zn) and oxygen (O) are present in the cap layer.

17. The light emitting device according to claim 12, further comprising:
on the ZnO film, a plasmon layer that plasmon-resonates with light emitted from the light emitting layer.

18. The light emitting device according to claim 17, wherein
the plasmon layer is formed of a metal thin film or metal fine particles.
